# EUROPÄISCHE PATENTANMELDUNG

(11) **EP 2 244 329 A1**
(43) Veröffentlichungstag der Anmeldung: **27.10.2010**
(21) Anmeldenummer: 10004095.5
(22) Anmeldetag: 17.04.2010
(51) Int. Cl.: H01M 10/44, G01R 31/36, H02J 7/04

(54) **Lade- und Diagnoseverfahrten für Batterien**

(30) Priorität: 20.04.2009 DE 102009002496
(71) Anmelder: Deutronic Elektronik GmbH, 84166 Adlkofen (DE)
(72) Erfinder: Dambrowski, Jonny, 84051 Essenbach (DE)
(74) Vertreter: Gustorf, Gerhard

(57) **Zusammenfassung**

Das Verfahren dient zum Laden und zur Alterungsdiagnose von Batterien, insbesondere verschlossener Bleibatterien für eine unterbrechungsfreie Stromversorgung (USV) mit einem Batteriemanagementsystem (BMS) mit Bestimmung der Parameter Temperatur, Umschaltzeit, Ladeende und Innenwiderstand. Das Ladeverfahren ist in eine Hauptladestufe und eine anschließende Nachlade- oder Vollladestufe unterteilt, wobei in der Hauptladestufe bei im wesentlichen konstantem Ladestrom ein Spannungsanstieg erzeugt wird, während in der Vollladestufe der Strom abfällt. Sowohl in der Hauptladestufe als auch in der Vollladestufe werden die Ladeparameter bei Temperaturänderungen und dem Batteriealter dynamisch angepasst.

## Beschreibung

Die Erfindung betrifft ein Verfahren zum Laden und zur Diagnose von Bleibatterien nach dem Oberbegriff des Anspruchs 1.

Das Verfahren gemäß der Erfindung wird sowohl bei Standard-Bleibatterien mit flüssigem Elektrolyten als auch bei sogenannten VRLA-Batterien angewandt. Bei letzteren handelt es sich um Bleibatterien mit festgelegten Elektrolyten wie beispielsweise AGM- oder Gel-Batterien.

Derartige Batterien werden vor allem für unterbrechungsfreie Stromversorgungen (USV) eingesetzt und mittels eines mehr oder weniger komplexen Batteriemanagementsystems (BMS) gesteuert, das die Ladung, Überwachung und Zustandsdiagnose der Batterie übernimmt.

Unterbrechungsfreie Stromversorgungen sind Stromversorgungen zusammen mit einem Energiespeicher, der eine gewisse Zeit bei Netzausfall die an der USV angeschlossene Anwendung mit Energie versorgt. Wie lange ein Energieversorgungsausfall durch den Energiespeicher überbrückt werden kann, hängt von der verwendeten Last (Anwendung) bzw. von der Dimension des Energiespeichers ab. In manchen Fällen lässt sich die Überbrückungszeit, die sich von einigen Sekunden bis zu Stunden erstrecken kann, zudem auch fest vom Hersteller oder Anwender einstellen. Die am häufigsten verwendeten Energiespeicher in USV-Anlagen sind Bleibatterien verschiedener technologischer Ausführungen, wie verschlossene (Blei-AGM, Blei-Gel, Reinblei) oder geschlossene Bleibatterien (gewöhnliche Bleibatterien mit flüssigem Elektrolyt). USVs werden eingesetzt in Notstromversorgungen, Alarm- und Brandmeldeanlagen, Bahnanwendungen, in der Automatisierungstechnik, im Medizinbereich, Telekommunikationsbereich oder in Wind- und Solaranlagen.

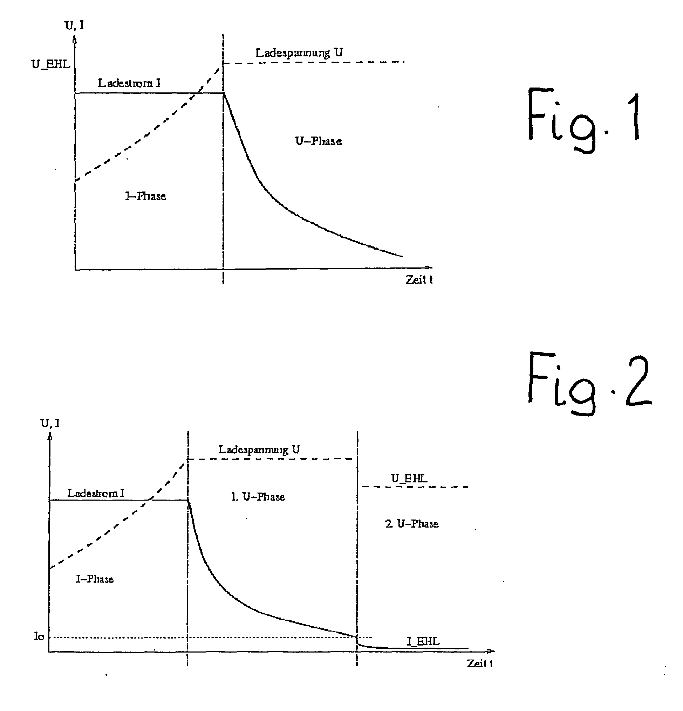

Für gewöhnlich werden im USV-Bereich die Bleibatterien mit sogenannten IU-Kennlinien (vgl. Fig. 1) geladen. Das bedeutet insbesondere, dass über die gesamte Lebensdauer der Batterie in der Applikation die sogenannte Erhaltungsladespannung (EHL-Spannung) permanent an der Batterie anliegt. Folglich wird dem Versorgungsnetz permanent Energie für die Batterieerhaltungsladung entzogen. 80% dieser Energie wird sinnlos in Überladung vernichtet. Im Einzelnen ergeben sich folgende weitere Nachteile:
1. Beschleunigte Alterung aufgrund von Wasserverlust und Korrosion der positiven Gitter. Dies ist besonders für verschlossene Bleibatterien problematisch, da das Nachfüllen von Wasser nicht möglich ist.
2. Beschleunigte Alterung aufgrund des Auseinanderlaufen der Einzelladezustände der Blöcke bzw. Zellen. Die Egalisierung der Einzelzellspannungen geht auf Kosten der Lebensdauer des Gesamtbatteriesystems, da die Alterung inhomogen über die Zellen verteilt ist. Besonders sind davon Blei-AMG und Blei-Gelbatterien betroffen.
3. Eine Analyse des Standes der Technik zeigt, dass bekannte BMS kein thermisches Management für die Batterien enthalten, insbesondere keinen Schutz vor thermischem Durchgehen und keine automatisierte Ladespannungstemperaturkompensation. Besonders in den Anwendungen im Bereich der Bahn oder Alarm- und Brandmeldeanlagen, wo die USV-Anlage außerhalb von klimatisierten Gebäuden betrieben wird, ist eine manuelle Einstellung der Ladespannung für Sommer-Winter-Betrieb völlig absurd.
4. Beschleunigte Alterung aufgrund von Mangelladung. Die Versorgungsqualität in USV-Anlagen ist sehr unterschiedlich. In Fällen, in denen es häufig (z. B. durchschnittlich einmal pro Monat) zu einem Netzversorgungsausfall kommt, besteht die Gefahr von Mangelladung und damit eines vorzeitigen Ausfalls der Batterie durch Sulfatierung. Auch dies betrifft besonders Bleibatterien mit Blei-Kalzium-Gittertechnologie, die den heutigen Standard - gegenüber den früher verwendeten Blei-Antimon-Gittern - einnehmen.

Mit zunehmender Alterung steigt bei verschlossenen Bleibatterien der für die Vollladung erforderliche Ladestrom exponentiell an. Entsprechend steigt der permanente Energieverbrauch unter dem IU-Laderegime exorbitant an.

Wie oben bereits erwähnt steigt bei verschlossenen Bleibatterien mit zunehmendem Alter der für die Vollladung notwendige Ladestrom. Die Ursache für dieses Phänomen liegt am sogenannten Sauerstoffkreislauf. Im Laufe des Lebens einer verschlossenen Bleibatterie bilden sich immer mehr Luft-Kanäle zwischen den Elektroden, in denen der an der positiven Elektrode gebildete Sauerstoff nahezu ungehindert zur negativen Elektrode diffundieren kann und dort mit H⁺-Ionen zu Wasser rekombiniert. Da die Reaktion exotherm ist, entsteht eine nicht unerhebliche Menge an Wärme, die die Batterie zusätzlich aufheizt. Je älter die Batterie ist, desto früher setzt beim Wiederaufladen verschlossener Bleibatterien der Sauerstoffkreislauf ein und desto größer ist gegen Ende der Ladung der Anteil vom Ladestrom, der für den Sauerstoffkreislauf aufgewendet werden muss, um die Batterie noch vollladen zu können.

Bei der IU-Kennlinie steigt der EHL-Strom mit zunehmendem Alter der Bleibatterie an, bis er die Leistungsgrenze des Ladegeräts erreicht hat bzw. die Batterie unter Umständen thermisch durchgeht (überhitzt). Bei der ebenfalls im USV-Bereich verwendeten IUoU-Ladekennlinie (vgl. Fig. 2) kommt noch folgendes Problem hinzu: Die Umschaltung von der Starkladephase (1. U-Phase), bei der mit relativ hoher Ladespannung von ca. (2.40-2.50) V/Z geladen wird, auf die kleinere EHL-Spannung (2. U-Phase) geschieht, wenn der Ladestrom I_{L} in der 1. U-Phase eine gewisse starre Grenze I_{O} ≈ 0.04C (4% der Kapazität in Ampere) unterschritten hat. Im Laufe der Betriebszeit verschlossener Bleibatterien wird sich schließlich I_{L} > I_{O} einstellen, so dass die Umschaltung auf die kleinere EHL-Spannung nicht erfolgt. Rudimentäre Schutzmechanismen, wie die Umschaltung über den Ladefaktor (LF) oder eine maximale Ladezeit, können die Auswirkungen etwas minimieren, jedoch sind diese in der Praxis meist ebenso starr und ferner relativ großzügig ausgelegt, so dass auch hier eine beschleunigte Alterung der Bleibatterie vorliegt. Jegliche Überladung trocknet das Vlies von AGM-Batterien durch den einhergehenden Wasserverlust mehr und mehr aus. Das wiederum kurbelt den Sauerstoffkreislauf an. Ist erst der kritische Sättigungsgrad von ca. 90% unterschritten, nehmen die oben beschriebenen und sich selbst beschleunigenden Prozesse drastisch zu, so dass das Ende Lebensdauer der Bleibatterie bald erreicht sein wird.

Die Folgerung hieraus ist, dass die Ladetechnik einen entscheidenden Einfluss auf den Sauerstoffkreislauf hat und also eine wesentliche Einflussgröße für die Gebrauchsdauer verschlossener Bleibatterien darstellt.

Die obigen Ausführungen erhellen die Einsicht, dass es signifikante Unterschiede in der Ladecharakteristik zwischen geschlossenen und verschlossenen Systemen gibt. Während die Ladeparameter für den ersten Typ über die gesamte Lebensdauer nahezu konstant bleiben können, sollten sie sich im zweiten Fall mit zunehmendem Alter der Batterie ändern. Gerade diese Dynamik und die deutlich höhere Temperaturempfindlichkeit der Ladecharakteristik von verschlossenen Bleibatterien motivieren es, intelligente, selbstadaptierende Ladealgorithmen zu entwickeln.

Die Lösung dieses Problems ergibt sich aus den Merkmalen des Patentanspruchs 1. Danach ist das Ladeverfahren unterteilt in eine Hauptladestufe und eine anschließende Nachlade-, auch Erhaltungslade-(EHL)- oder Vollladestufe genannt, wobei in der Hauptladestufe bei im wesentlichen konstantem Ladestrom die Ladezeit und die Spannungsantwort der Batterie zur Umschaltung der Stromstufen ausgewertet werden, während in der Vollladestufe mehrere redundant wirkende Vollladeerkennungsmechanismen zum Einsatz kommen. Sowohl in der Hauptladestufe als auch in der Vollladestufe werden die Ladeparameter dem Alter und der Temperatur der Batterie dynamisch angepasst.

Nach einem Merkmal der Erfindung ist vorgesehen, dass in der Vollladestufe der EHL-Strom, die EHL-Zeit (maximale Zeit zur Vollladung bzw., was aequivalent dazu ist, die maximal zulässige Ladungsmenge zur Vollladung) und die Steigung dU/dt dynamisch mit der Temperatur angepasst werden, um somit Vollladung sowohl bei hohen als auch bei niedrigen Temperaturen zu ermöglichen und schädliche Überladung zu minimieren.

Nach einem weiteren Merkmal der Erfindung werden die Vollladung und damit ein Überladeschutz durch die verschiedenen, zum Teil redundant wirkenden Mechanismen -dU, dU/dt(T), Ladefaktor, maximale Batteriespannung, EHL-Strom(T) und EHL-Zeit(T) erreicht. Man beachte, dass erst durch Kombination dieser Vollladeerkennungs- bzw. Überladschutzmechanismen - in ihren quantitativen Größen - der Ladealgorithmus für ge- und verschlossene Bleibatterien einsetzbar wird. Ebenso berücksichtigt diese Kombination bereits Alterungsphänomene von Bleibatterien.

Das Verfahren gemäß der Erfindung ist in der Lage, Alterungsphänomene von Bleibatterien zu erkennen und diese Informationen zu nutzen, um die Ladeparameter EHL-Strom, EHL-Zeit und -dU in der Vollladephase dem Batteriealter anzupassen. Ein Maß für die Batteriealterung wird dabei aus
1. der Spannungsantwort auf den Ladestrom in der EHL-Phase,
2. dem historischen Verlauf des Innenwiderstandes seit Inbetriebnahme der USV-Batterie,
3. einer vorhergehenden Triggerung von t_EHL (zeitalgorithmus gesteuerte EHL)
gewonnen. Dadurch wird schädliche Mangelladung vermieden, welche sonst zu einem Frühausfall der Batterie durch Sulfatierung führen würde.

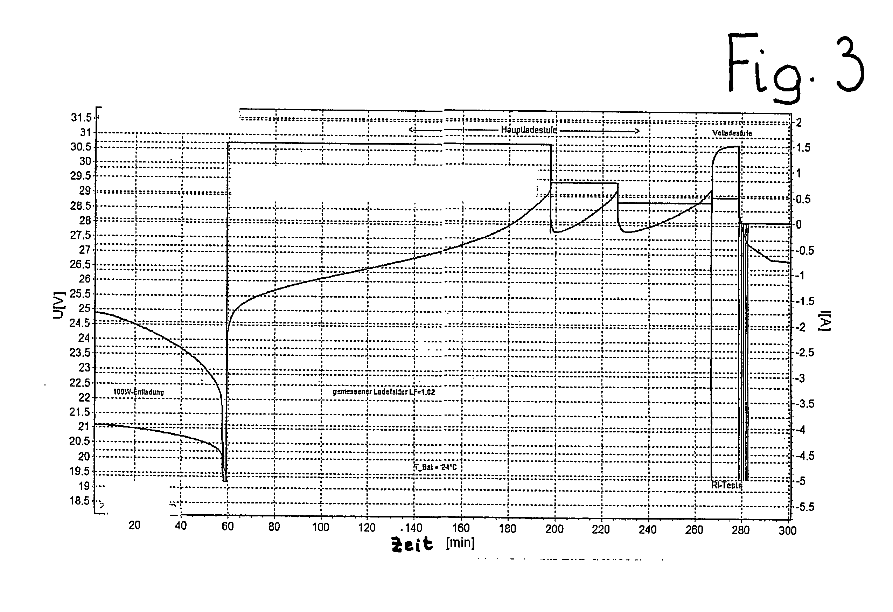

Der selbstadaptierende Ladealgorithmus für verschlossene Bleibatterien gemäß der Erfindung ist in einem qualitativen Diagramm der Figur 3 dargestellt. Mit ihm wird eine Reihe von wesentlichen Vorteilen erzielt:
1. Ein hoher Ladewirkungsgrad von 98% (Ladefaktor LF=1,02) konnte für verschiedene Batteriehersteller nachgewiesen werden. Damit ergeben sich eine geringere Überladung, ein geringerer Wasserverlust und damit Erhaltung eines möglichst hohen Sättigungsgrades für verschlossene Bleibatterien sowie eine signifikant höhere Lebensdauer. An dieser Stelle sei betont, dass gerade Blei-AGM-Batterien eine deutlich niedrigere Überladefähigkeit aufweisen als Blei-Standard-Batterien. Aber gerade dieser technologische Typ ist kostengünstig und wird zunehmend mehr im USV-Sektor eingesetzt.
2. Keine permanent anliegende Ladespannung. Die Batterie verbleibt größtenteils im sogenannten OCV-Zustand (open circuit voltage), d. h. im Leerlauf. Das Tastverhältnis der Nachladephasen liegt unter 0,1%, so dass weniger Wasserverlust und Korrosion und damit eine geringere Alterung sowie eine signifikant höhere Lebensdauer erzielt werden. Innerhalb der OCV-Zeit sinkt der Ladezustand maximal um 5%, so dass auch in der OCV-Phase die Bleibatterie nahezu 100% vollgeladen bleibt.
3. Kein Auseinanderlaufen der Einzelladezustände der Zellen bzw. Batterieblöcke wie unter Ladung bei konstanter Spannung. Die Alterung des Gesamtbatteriesystems ist damit homogen.
4. Thermisches Management verhindert thermisches Durchgehen und adaptiert die Ladeparameter selbsttätig, was eine Vollladung sowohl bei hohen wie auch bei niedrigen Temperaturen ermöglicht.
5. Die Ladekennlinie berücksichtigt Alterungseffekte gerade von verschlossenen Bleibatterien, die sich besonders gegen Ladeende einstellen. Eine dynamische Adaption der Ladeparameter ist daher notwendig und dies gilt insbesondere für die Ladeerkennung. Gerade letzteres ist u. a. für den sehr guten Ladewirkungsgrad von 98% verantwortlich.
6. Regeneration moderat sulfatierter Bleibatterien. Es konnte an einem konkreten Fall nachgewiesen werden, dass die aktuelle Kapazität nach nur fünf Tagen im EHL-Betrieb um ca. 12,5% gestiegen ist.
7. Optimierung des Verfahrens für einen Batterietemperaturbereich zwischen etwa -20°C und +50°C.

Aus Figur 3 ergibt sich, dass der Ladealgorithmus gemäß der Erfindung die sich durch den Sauerstoffkreislauf und die Betriebstemperatur ändernde Ladecharakteristik verschlossener Bleibatterien berücksichtigt. Daraus resultieren nicht nur eine deutlich längere Gebrauchsdauer der Bleibatterie in der Applikation, sondern auch ein breiteres Anwendungsspektrum der USV-Produkte für Bereiche, in denen hohe Temperaturschwankungen vorliegen, etwa bei einem Betrieb in nicht klimatisierten Räumen.

Es ist von erheblicher Bedeutung für den Anwender, dass graduelle Performanceminderungen der Energiespeicher vom BMS möglichst frühzeitig erkannt und angezeigt werden, um damit eine möglichst rasche und vollständige Systemzuverlässigkeit wiedeherzustellen. Die oben bereits genannten Überbrückungszeiten von einigen Sekunden bis hin zu einigen Stunden deuten schon an, dass im USV-Bereich Entladungen mit
1. hoher Leistung, d. h. hohe Entladeströme für kurze Zeit (Sekunden bis Minuten) oder
2. hoher Energie, d. h. niedrige Entladeströme für lange Zeit (einige Minuten bis Stunden)
vorkommen können. Dem Rechnung tragend sind Verfahren für die Alterungszustandsdiagnosen zu wählen.

Im ersten Fall wurde ein Verfahren entwickelt, das auf Innenwiderstandsmessungen basiert. Der ohmsche Innenwiderstand einer Batterie gibt Auskunft über die Hochstromentladefähigkeit. Ein gradueller Anstieg des Innenwiderstandes wird erkannt und zur Anzeige gebracht. Wesentlich an dieser Stelle ist, dass der ohmsche Innenwiderstand einer Bleibatterie hochgradig nichtlinear temperaturabhängig ist. Bereits im Bereich von 0°C bis 25°C ändert sich der Innenwiderstand um gut 50%. Eine adäquate Zustandsdiagnose - gerade für jene USV-Anlagen, die außerhalb von klimatisierten Gebäuden betrieben werden - erfordert eine Temperaturkompensation des bei einer beliebigen Temperatur gemessenen Innenwiderstandes auf eine Normtemperatur. Erst damit lässt sich ein gradueller Anstieg des Innenwiderstandes detektieren, der beispielsweise im Automotivbereich bereits bei 30% zum Batterieaustausch führt.

Bei dem Ladeverfahren gemäß der Erfindung sind beide Ladestufen temperaturkompensiert, was bedeutet, dass viele Ladeparameter bei Temperaturänderungen dynamisch angepasst werden. Hierzu zählen die Grenzspannung zur Umschaltung der Stromstufen, die Anzahl der Stromstufen in der Hauptladestufe sowie der EHL-Strom, die EHL-Zeit und das Zeitintervall dt des dU/dt-Kriteriums in der Vollladestufe. Die Vollladeerkennung erfolgt also dynamisch und berücksichtigt neben Temperatureinflüssen auch Alterungseinflüsse, von denen insbesondere die VRLA-Batterien betroffen sind, weshalb hier gerade die alterungs- und temperaturkompensierte Detektion des Vollladezustands besonders wichtig ist.

Von erheblicher Bedeutung gemäß der Erfindung ist die temperaturkompensierte Zustandsdiagnose, die auf optimierten Innenwiderstandsmessungen zur Bestimmung der graduellen Veränderung der Hochstromentladefähigkeit von Bleibatterien basiert.

Der mit der Erfindung erzielte Nutzen für die Umwelt ist in zweierlei Hinsicht gegeben:
1. Energieersparnis: Mit den üblichen IU-Ladeverfahren (U_{EHL} = 2,25 V/Z) ist der Energieverbrauch für die Erhaltungsladung um etwa das Zehnfache größer als mit dem neu entwickelten Ladeverfahren. Pro 100Ah ist dies bei einem 48V-System eine Ersparnis von ca. 40kWh/Jahr. Je größer demnach die USV-Anlage ist, desto drastischer wirkt sich die Energieersparnis aus. Dabei sind jedoch die Kosten des vorzeitigen Batterietausches aufgrund der sich durch das IU-Ladeverfahren ergebenden reduzierten Lebensdauer der Batterien noch nicht berücksichtigt.
2. Rohstoffersparnis:
   - Die Überladung beim Standard IU-Ladeverfahren beträgt ca. 80%, beim neu entwickelten Ladealgorithmus ca. 20%. Das bedeutet, dass die Energie in die Überladung beim IU-Verfahren ca. 40 mal so hoch ist wie beim neu entwickelten Ladeverfahren. Offensichtlich führt dies zu einer drastischen Erhöhung der Lebensdauer der Bleibatterien.
   - Die beiden oben erläuterten Diagnoseverfahren bieten über den breiten Einsatzbereich der USV-Systeme eine gute Zustandsdiagnose, die dazu führt, dass Batterien nicht - wie häufig üblich - pauschal nach zwei Jahren ausgetauscht werden, sondern ein Austausch erfolgt genau dann, wenn das BMS eine Performanceminderung detektiert, dass in naher Zukunft eine Gefährdung für die Funktion der Anwendung besteht. Das spart Rohstoffe, die gerade im Batteriesektor in den letzten Jahren massiven Preiserhöhungen unterworfen waren.

Insgesamt lässt sich feststellen, dass der neu entwickelte Ladealgorithmus zusammen mit der Zustandsdiagnose erhebliche Energieeinsparungen ermöglicht und die Austauschintervalle wesentlich verlängert. Die Erfindung eignet sich sowohl für Bleibatterien im stationären Anwendungsbereich als auch für Fahrzeugbatterien, z. B. in Gabelstaplern.

## Patentansprüche

1. Verfahren zum Laden und zur Alterungsdiagnose von Batterien, insbesondere verschlossener Bleibatterien für eine unterbrechungsfreie Stromversorgung (USV) mit einem Batteriemanagementsystem (BMS) mit Bestimmung der Parameter Umschaltzeit, Ladeende und Innenwiderstand, wobei das Ladeverfahren in eine Hauptladestufe und eine anschließende Nachlade- oder Vollladestufe (EHL) unterteilt ist und in der Hauptladestufe bei im wesentlichen konstantem Ladestrom die Ladezeit und die Spannungsantwort der Batterie zur Umschaltung der Stromstufen ausgewertet wird, während in der Vollladestufe mehrere redundant wirkende Vollladeerkennungsmechanismen zum Einsatz kommen, **dadurch gekennzeichnet, dass** sowohl in der Hauptladestufe als auch in der Vollladestufe die Ladeparameter dem Alter und der Temperatur der Batterie dynamisch angepasst werden.

2. Verfahren nach Anspruch 1, **dadurch gekennzeichnet, dass** in der Hauptladestufe der Konstantstrom auf wenigstens eine niedrigere Konstantstromstufe umschaltet, wenn die Ladespannung eine von der Temperatur abhängige Grenzspannung (U₁) erreicht.

3. Verfahren nach Anspruch 1 oder 2, **dadurch gekennzeichnet, dass** in der Vollladestufe der EHL-Strom, die EHL-Zeit (Vollladezeit) und die Steigung dU/dt dynamisch mit der Temperatur angepasst werden, um somit Vollladung bei hohen wie niedrigen Temperaturen zu ermöglichen und schädliche Überladung zu minimieren.

4. Verfahren nach einem der vorhergehenden Ansprüche, **dadurch gekennzeichnet, dass** die Vollladung und damit ein Überladeschutz durch die verschiedenen, zum Teil redundant wirkenden Mechanismen -dU, dU/dt(T), Ladefaktor, U_{Bat.max}, EHL-Strom(T) und EHL-Zeit(T) erreicht werden.

5. Verfahren nach einem der vorhergehenden Ansprüche, **dadurch gekennzeichnet, dass** dieses Alterungsphänomene von Bleibatterien erkennt und diese Information nutzt, um die Ladeparameter EHL-Strom, EHL-Zeit und -dU in der Vollladephase dem Batteriealter anzupassen.

6. Verfahren nach einem der vorhergehenden Ansprüche, **dadurch gekennzeichnet, dass** sich die Batterie nach der Vollladestufe anstelle einer permanent anliegenden Erhaltungsladespannung solange im Leerlauf befindet, bis der Ladezustand um maximal 5% abgesunken ist, worauf eine neue Nachladung einsetzt.

7. Verfahren nach einem vorhergehenden Ansprüche, **dadurch gekennzeichnet, dass** das Batteriemanagementsystem eine temperaturkompensierte Alterungsdiagnose von Bleibatterien sowohl des geschlossenen als auch des verschlossenen Typs umfasst.

8. Verfahren nach Anspruch 7, **dadurch gekennzeichnet, dass** die Alterungsdiagnose basiert auf einer Modellgleichung für die Temperaturkompensation des bei einer Temperatur T gemessenen ohmschen Innenwiderstandes, auf einer Normtemperatur To und auf einer optimierten Innenwiderstandsmessung selbst.
